# EUROPÄISCHE PATENTANMELDUNG

(11) **EP 3 647 801 A1**
(43) Veröffentlichungstag der Anmeldung: **06.05.2020**
(21) Anmeldenummer: 18203310.0
(22) Anmeldetag: 30.10.2018
(51) Int. Cl.: G01R 31/3185, G01R 31/317

(54) **VERFAHREN ZUR ÜBERPRÜFUNG EINES FPGA-PROGRAMMS**

(71) Anmelder: dSPACE digital signal processing and control engineering GmbH, 33102 Paderborn (DE)
(72) Erfinder: Kalte, Heiko, 33102 Paderborn (DE); Lubeley, Dominik, 33102 Paderborn (DE)

(57) **Zusammenfassung**

Verfahren zur Fehlererkennung eines ersten FPGA-Programms (1), wobei das FPGA-Programm (1) auf einem FPGA (2) ausgeführt wird, wobei der FPGA (2) mit einem Prozessor (3) verbunden ist, wobei auf dem Prozessor (3) ein Überwachungsprogramm (4) ausgeführt wird, wobei ein Signalwert (5, 6, 7, 8) aus dem FPGA-Programm (1) ausgelesen und dem Überwachungsprogramm (4) zugeleitet wird, wobei das Überwachungsprogramm (4) zur Erkennung von Fehlern den Signalwert (5, 6, 7, 8) mit einem Referenzwert (9) aus einer anderen Quelle vergleicht.

## Beschreibung

Die Erfindung betrifft ein Verfahren zur Überprüfung eines FPGA-Programms.

Trotz fehlerfreier RCP Simulatorhardware, elektrisch geprüfter Kommunikationsstrecken, korrekter FPGA Bitströme und korrekt programmiertem FPGA kann es in der Realität zu Fehlverhalten im FPGA Modell kommen. Einige dieser Fehler könnten zwar ggf. durch eine Simulation auf Modell- oder auf Gatterebene aufgedeckt werden, der Aufwand dieser Simulation, insbesondere die Erstellung der Testumgebung einschließlich der FPGA Umgebung kann jedoch sehr hoch sein, so dass die funktionale Prüfung in der realen Umgebung deutlich einfacher sein kann.

Aus dem "Spartan-6 FPGA Configuration User Guide UG380 (v2.10) March 31, 2017" ist es bekannt statische Konfigurationsdaten aus dem FPGA auszulesen und mit den Originaldaten zu vergleichen.

Vor diesem Hintergrund besteht die Aufgabe der Erfindung darin, ein Verfahren anzugeben, das den Stand der Technik weiterbildet.

Gegenstand der Erfindung ist ein Verfahren zur Fehlererkennung eines FPGA-Programms, wobei das FPGA-Programm auf einem FPGA ausgeführt wird, wobei der FPGA mit einem Prozessor verbunden ist, wobei auf dem Prozessor ein Überwachungsprogramm ausgeführt wird, wobei ein Signalwert aus dem FPGA-Programm ausgelesen und dem Überwachungsprogramm zugeleitet wird, wobei das Überwachungsprogramm zur Erkennung von Fehlern den Signalwert mit einem Referenzwert aus einer anderen Quelle vergleicht.

Signalwerte ändern sich während der Ausführung des FPGA-Programms. Insbesondere können Signalwerte in Registern gespeichert werden, wobei die Register während der Ausführung des FPGA-Programms aktualisiert werden. Darunter fallen auch Signalwerte in Schattenregistern, wie sie in der EP3244326A1 offenbart sind.

Ein Vorteil des erfindungsgemäßen Verfahrens ist, dass Fehler erkannt werden können, die nicht auf fehlerhafte Konfigurationsdaten zurückzuführen sind. Bspw. kann erkannt werden, dass sich eine Schaltung anders verhält als bei der Entwicklung oder Simulation vermutet. Dies kann bspw. durch Fehler im Compiler oder thermische Änderungen zur Laufzeit geschehen. Nach Erkennung des Fehlers kann darauf reagiert werden, bspw. durch Ausgabe einer Fehlermeldung, Anhalten des FPGA-Programms oder Starten eines Debug-Programms.

Es versteht sich, dass auch eine Vielzahl an Signalwerten mit dem gleichen Referenzwert verglichen werden können. Ebenso kann ein Signalwert mit einer Vielzahl an Referenzwerten verglichen werden. Für jeden Vergleich kann dabei eine andere Regel gelten, ob ein Fehler erkannt wird oder nicht. So kann bei einem Vergleich ein Fehler vorliegen, wenn der Signalwert kleiner ist als der Referenzwert und bei einem anderen Vergleich ein Fehler vorliegen, wenn der Signalwert größer ist als der Referenzwert.

Der Prozessor, auf dem das Überwachungsprogramm ausgeführt wird, kann jede Form von Recheneinheit sein. Sowohl ein universeller Prozessor, als auch ein in einem FPGA implementierter Prozessor, ein speziell für diese Aufgabe geschaffener Prozessor (ASIC) als auch ein System-On-Chip (SOC) können als Ausführungseinheit für das Überwachungsprogramm dienen. Vorteilhafterweise wird der Prozessor nicht auf dem zu überwachenden FPGA implementiert.

In einer Weiterbildung wird eine Vielzahl an Vergleichen zwischen Signalwerten und Referenzwerten durchgeführt und miteinander verknüpft.

Durch die Verknüpfung können auch komplexere Fehler erkannt werden. Bspw. kann ein Fehler vorliegen, wenn der Signalwert kleiner ist als ein erster Grenzwert und gleichzeitig größer als ein zweiter Grenzwert. Ein solcher Fehler lässt sich durch einen einzelnen Vergleich nicht erfassen. In einem anderen Beispiel kann ein Fehler vorliegen, wenn ein erster Signalwert gleich einem ersten Referenzwert ist und gleichzeitig ein zweiter Signalwert gleich einem zweiten Referenzwert ist. Ein solcher Fehler lässt sich durch einen einzelnen Vergleich nicht erfassen.

In einer Weiterbildung werden Signalwerte häufiger mit Referenzwerten verglichen werden, wenn ihre Speicherstellen und/oder die Logik, aus der sich die Werte der Speicherstellen ergeben einer höheren thermischen Belastung ausgesetzt sind.

Durch thermische Belastung, also höhere Temperaturen, steigt im Allgemeinen die Wahrscheinlichkeit für Fehler in Speichern und fehlerhafte Ausgaben von Logikblöcken. Daher ist es vorteilhaft Signalwerte, welche in Speicherstellen mit höherer thermischer Belastung gespeichert werden, häufiger mit Referenzwerten zu vergleichen als Signalwerte, welche in Speicherstellen mit niedrigerer thermischer Belastung gespeichert werden.

In einer Ausgestaltung wird die thermische Belastung der Speicherstellen durch eine Simulation geschätzt.

Die thermische Belastung der Speicherstellen hängt stark von der Aktivität der logischen Elemente in der direkten Umgebung der Speicherstellen ab. Bei jedem Schaltvorgang eines logischen Elementes wird Wärme erzeugt. Durch eine Simulation kann geschätzt werden, welche logischen Elemente des FPGA zur Laufzeit des FPGA-Programms häufiger schalten werden als andere logische Elemente. Signalwerte in Speicherstellen in der Nähe der häufiger schaltenden logischen Elemente werden dann häufiger mit Referenzwerten verglichen als Signalwerte in Speicherstellen in der Nähe von seltener schaltenden logischen Elementen.

In einer vorteilhaften Ausgestaltung ist der Referenzwert ein vorgegebener Wert.

Vorgegebene Referenzwerte liegen dem Überprüfungsprogramm vor der Ausführung des FPGA-Programms vor. Bei vorgegebenen Referenzwerten lässt sich der Vergleich mit den ausgelesenen dynamischen Werten sehr schnell durchführen, da die Referenzwerte nicht noch beschafft werden müssen. Die vorgegebenen Referenzwerte können bspw. Grenzwerte für Signale sein. Durch einen Vergleich kann dann festgestellt werden, ob sich ein Signalwert innerhalb der festgelegten Grenzen befindet.

In einer weiteren Ausgestaltung benennen der Signalwert und der Referenzwert jeweils eine Speicheradresse im BlockRAM des FPGA.

Der dynamische Wert kann bspw. einen Lese- oder Schreibzugriff auf das BlockRAM im FPGA adressieren. Der Referenzwert kann in diesem Fall ein Grenzwert für einen Speicherbereich sein. Durch diesen Vergleich kann erkannt werden, ob ein Lese- oder Schreibzugriff auf einen unzulässigen Speicherbereich erfolgt. Alternativ kann für einzelne Speicheradressen ein Referenzwert angegeben werden. Bspw. können einzelne Bits angeben, ob ein Zugriff auf die Speicheradresse als Fehler gewertet wird.

In einer Ausgestaltung wird ein Fehler des FPGA-Programms festgestellt, wenn der Signalwert größer als ein erster Referenzwert und/oder kleiner als ein zweiter Referenzwert ist.

In einer vorteilhaften Ausgestaltung wird bei einem Schreibzugriff auf den BlockRAM des FPGA ein Referenzwert gesetzt.

Durch das Setzen eines Referenzwertes bei einem Schreibzugriff kann der zulässige Speicherbereich des BlockRAM aktualisiert werden. Dies ist bspw. sinnvoll, wenn Lesezugriffe auf uninitialisierten Speicher erkannt werden sollen. Durch einen Schreibzugriff wird der Speicherbereich initialisiert und ein Lesezugriff darauf zulässig. Vor dem Schreibzugriff ist ein Lesezugriff unzulässig.

Zur Umsetzung kann eine Logik im FPGA implementiert werden, welche Schreibzugriffe auf den BlockRAM überwacht. Bei jedem Schreibzugriff wird der entsprechende Referenzwert aktualisiert. In einer Ausgestaltung wird jeweils die größte Speicheradresse aller bisher erfolgten Schreibzugriffe als Referenzwert genutzt. Ein Lesezugriff auf eine größere Speicheradresse ist als Fehler zu werten. In einer weiteren Ausgestaltung wird jeweils die kleinste Speicheradresse aller bisher erfolgten Schreibzugriffe als Referenzwert genutzt. In Lesezugriff auf eine kleinere Speicheradresse ist als Fehler zu werten. Der Referenzwert auf die größte Speicheradresse und der Referenzwert auf die kleinste Speicheradresse können alternativ oder in Kombination genutzt werden.

In vorteilhaften Ausgestaltung wird der BlockRAM in eine Vielzahl von Partitionen unterteilt und für jede Partition zumindest ein Referenzwert verwendet.

Für jede Partition kann ein Referenzwert auf die größte Speicheradresse und/oder ein Referenzwert auf die kleinste Speicheradresse genutzt werden. Durch die Unterteilung in Partitionen wird die Überwachung auf Lesezugriffe auf unzulässige Speicherbereiche wesentlich sicherer. Falls eine Partition nur eine einzelne Speicheradresse umfasst, reicht ein einzelnes Bit als Referenzwert. Ein Aufteilung des BlockRAM in so viele Partitionen wie Speicheradressen vorhanden sind, ermöglicht eine vollständige Überwachung des BlockRAM.

In einer Ausgestaltung wird der Prozessor mit einem weiteren FPGA verbunden und der Referenzwert aus dem weiteren FPGA ausgelesen.

Durch das Auslesen des Referenzwertes aus einem weiteren FPGA ist es möglich die Kommunikation zwischen dem FPGA und dem weiteren FPGA zu überprüfen. Dabei wird der Signalwert aus dem FPGA vor der Übertragung an den weiteren FPGA ausgelesen und der Referenzwert nach der Übertragung aus dem weiteren FPGA ausgelesen. Sollten der Signalwert und der Referenzwert nicht identisch sein, wird ein Fehler in der Kommunikation erkannt. Eine Identität zwischen Signalwert und Referenzwert kann auch indirekt gegeben sein, wenn der ausgelesene Signalwert vor der Übertragung noch im FPGA auf bekannte Weise verändert wird und/oder der übertragene Wert im weiteren FPGA vor dem Auslesen als Referenzwert auf bekannte Weise verändert wird. Eine solche Veränderung kann bspw. aus dem Programmcode des FPGA bzw. weiteren FPGA bekannt sein.

In einer alternativen Ausgestaltung wird der Referenzwert dynamisch im Prozessor erzeugt.

Bei einer dynamischen Erzeugung wird der Referenzwert zur Laufzeit des FPGA im Prozessor erzeugt. Ein Beispiel für einen Referenzwert, der im Prozessor erzeugt wird, ist ein Wert, der vom Prozessor an den FPGA gesendet wird. Der vom FPGA empfangene Wert kann dann als Signalwert ausgelesen werden und mit dem vom Prozessor gesendeten Wert verglichen werden. Stimmen die Werte nicht überein, so liegt ein Kommunikationsproblem vor und der Fehler wird erkannt. Ein anderes Beispiel ist ein Wert, der vom FPGA an den Prozessor gesendet wird. Hier ist darauf zu achten, dass der FPGA den Wert auf einem anderen Weg an den Prozessor sendet als das Überprüfungsprogramm den Wert ausliest. Stimmen der vom FPGA an den Prozessor gesendete Wert und der vom Überprüfungsprogramm ausgelesene Wert nicht überein, so liegt ein Kommunikationsproblem vor und der Fehler wird erkannt.

In einer Ausgestaltung sendet das Überwachungsprogramm einen Stimulationswert an den FPGA.

Unter Kenntnis des Stimulationswertes kann das Überwachungsprogramm vorhersagen welchen Wert zu welchem Zeitpunkt der Signalwert annehmen soll. Stimmt der ausgelesene Signalwert nicht mit dem vorhergesagten Wert überein, so wird ein Fehler erkannt. Der Stimulationswert kann bspw. als Ersatz für einen Eingangswert an den FPGA geschickt werden. Alternativ kann der Stimulationswert über einen Konfigurationsport des FPGA gesendet werden und einen internen Wert des FPGA überschreiben.

In einer Ausgestaltung überschreibt der Stimulationswert eine Konstante im FPGA-Programm.

Das Überschreiben der Konstanten kann bspw. mit einer Schieberegisterkette im FPGA durchgeführt werden. Für jede Konstante, die überschrieben werden können soll, wird ein Register in der Schieberegisterkette implementiert. Die Werte aus der Schieberegisterkette werden durch ein "enable-Signal" synchron in Arbeitsregister übernommen und damit die Konstanten überschrieben. Diese und weitere Methoden zum Überschreiben von Konstanten sind in EP2963541A1 offenbart.

In einer vorteilhaften Ausgestaltung wird der dynamische Wert über eine Readback-Schnittstelle aus dem FPGA ausgelesen.

Das Auslesen von dynamischen Werten aus dem FPGA über eine Readback-Schnittstelle hat u.a. den Vorteil, dass keine zusätzliche Ausleselogik in das FPGA-Programm eingebracht werden muss. Dies spart Ressourcen und ermöglicht damit größere FPGA-Programme zu nutzen. Verfahren zum Auslesen von Signalwerten aus dem FPGA über eine Readback-Schnittstelle sind bspw. in EP2765528A1 und EP3244326A1 offenbart. Eine Readback-Schnittstelle ist bspw. der "internal configuration access port", kurz ICAP.

Die Erfindung wird nachfolgend unter Bezugnahme auf die Zeichnungen näher erläutert. Hierbei werden gleichartige Teile mit identischen Bezeichnungen beschriftet. Die dargestellten Ausführungsformen sind stark schematisiert, d.h. die Abstände und die lateralen und die vertikalen Erstreckungen sind nicht maßstäblich und weisen, sofern nicht anders angegeben auch keine ableitbare geometrische Relationen zueinander auf. Darin zeigt:
- Figur 1: eine schematische Ansicht auf eine erste erfindungsgemäße Ausführungsform,
- Figur 2: eine schematische Ansicht auf eine zweite erfindungsgemäße Ausführungsform,
- Figur 3: eine schematische Ansicht auf eine dritte erfindungsgemäße Ausführungsform,
- Figur 4: eine schematische Ansicht auf eine vierte erfindungsgemäße Ausführungsform,
- Figur 5: eine schematische Ansicht auf eine fünfte erfindungsgemäße Ausführungsform.

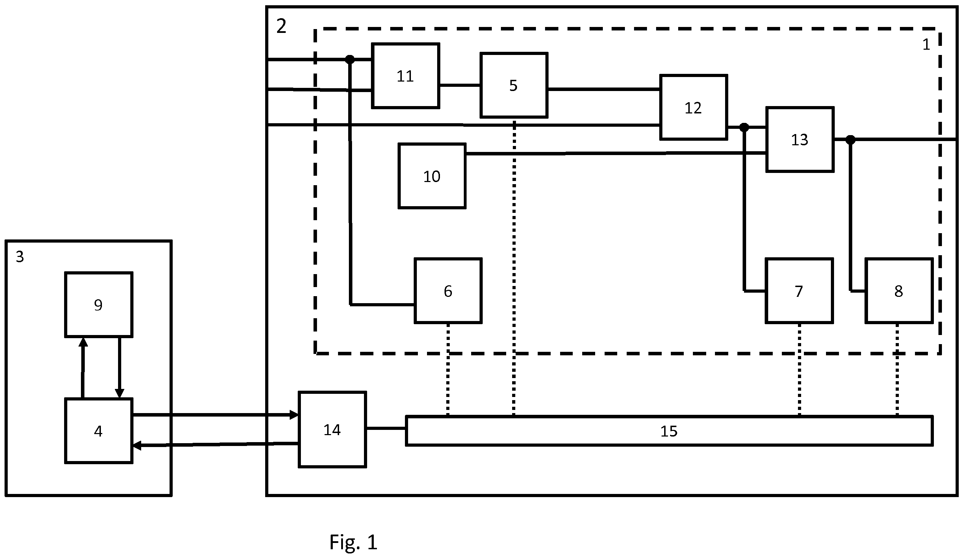

Die Abbildung der Figur 1 zeigt ein FPGA-Programm 1, dass auf einem FPGA 2 ausgeführt wird. Der FPGA ist mit einem Prozessor 3 verbunden. Auf dem Prozessor wird ein Überwachungsprogramm 4 ausgeführt. Das FPGA-Programm 1 umfasst eine Vielzahl an Registern, in denen Signalwerte gespeichert werden und eine Vielzahl an Logikelementen. Signalwerte werden während der Ausführung des FPGA-Programms geändert. Ein erster Signalwert 5 wird in einem ersten Register gespeichert. Der erste Signalwert ist hier der Ausgangswert eines ersten Logikelementes 11. Das erste Register dient als Zwischenspeicher für den ersten Signalwert 5 und stellt ihn einem zweiten Logikelement 12 als Eingangswert zu Verfügung. Ein zweiter Signalwert 6 ist ein Eingangswert des ersten Logikelementes und wird dem FPGA 2 von außen zugeführt. Der zweite Signalwert 6 wird in einem zweiten Register gespeichert. Das zweite Register dient nicht als Zwischenspeicher, da es den zweiten dynamischen Wert keinem weiteren Element des FPGA-Programms zur Verfügung stellt. Das zweite Register dient lediglich dazu den zweiten Signalwert 6 für das Auslesen vorzuhalten. Das zweite Register wird auch als Schattenregister bezeichnet, da es für die Funktionalität des FPGA-Programms keine Bedeutung hat. Ein dritter Signalwert 7 ist ein Ausgangswert des zweiten Logikelementes 12 und gleichzeitig ein Eingangswert eines dritten Logikelementes 13. Der dritte Signalwert 7 wird in einem dritten Register gespeichert. Das dritte Register ist wie das zweite Register ein Schattenregister. Ein vierter Signalwert 8 ist ein Ausgangswert des dritten Logikelementes 13 und verlässt den FPGA 2. Der vierte Signalwert 8 wird in einem vierten Register gespeichert. Das vierte Register ist wie das zweite Register ein Schattenregister. Eine Konstante 10 ist in einem Register gespeichert. Das Register stellt die Konstante 10 als Eingangswert des dritten Logikelementes 13 zu Verfügung.

Auf dem Prozessor 3 ist ein Referenzwert 9 in einem Speicherelement gespeichert. Der Referenzwert 9 ist damit ein vorgegebener Referenzwert. Der Referenzwert 9 kann vom Überwachungsprogramm 4 gelesen werden. Das Überwachungsprogramm 4 kommuniziert mit einem im FPGA vorhandenen Controller 14. Das Überwachungsprogramm 4 teilt dem Controller 14 mit, welche Signalwerte 5, 6, 7, 8 zu welchem Zeitpunkt ausgelesen werden sollen. Der Controller 14 liest über eine interne Ausleseschnittstelle 15 die vom Überwachungsprogramm 4 angeforderten Signalwerte 5, 6, 7, 8 aus den Registern aus und leitet sie an das Überwachungsprogramm 4 weiter. Eine interne Ausleseschnittstelle 15 ist bspw. der "internal configuration access port", kurz ICAP.

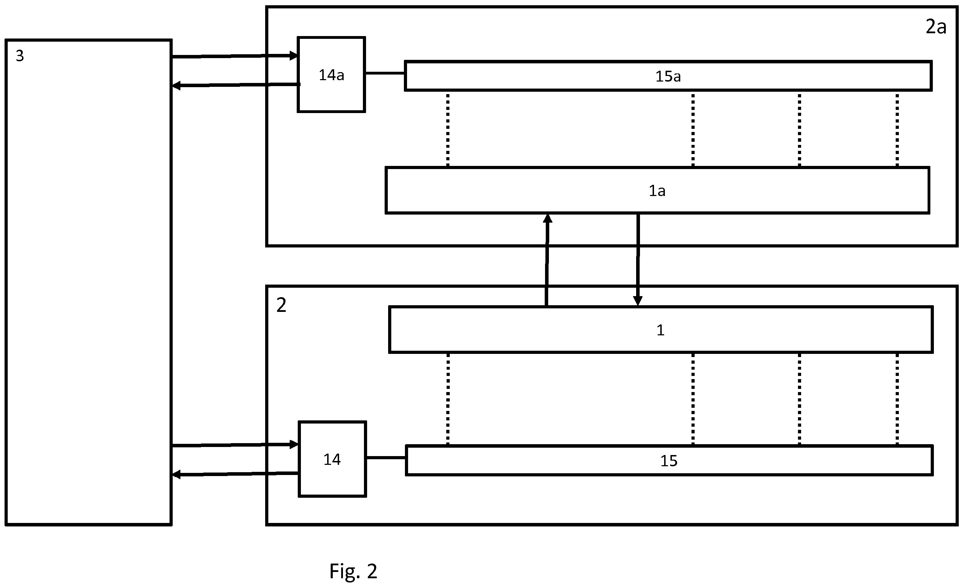

In der Abbildung der Figur 2 ist eine weitere Ausführungsform dargestellt. Im Folgenden werden nur die Unterschiede zu der Abbildung der Figur 1 erläutert. Der FPGA 2 mit dem FPGA-Programm 1 und der Prozessor 3 sind genauso aufgebaut wie in Figur 1 beschrieben, werden hier jedoch zur besseren Übersicht vereinfacht dargestellt. Zusätzlich ist ein weiterer FPGA 2a vorhanden. Der weitere FPGA 2a ist genauso aufgebaut wie der FPGA 2. Auf dem weiteren FPGA 2a wird ein weiteres FPGA-Programm 1a ausgeführt. Der weitere FPGA 2a ist sowohl mit dem FPGA 2 als auch mit dem Prozessor 3 verbunden. Das FPGA-Programm 1 und das weitere FPGA-Programm 1a können Daten austauschen. Der Prozessor 3 kann mit einem im weiteren FPGA 2a vorhandenen Controller 14a kommunizieren und diesem mitteilen, welche Werte aus dem weiteren FPGA-Programm 1a ausgelesen werden sollen. Das Überwachungsprogramm 4 liest aus dem FPGA-Programm 1 einen Signalwert aus, den das FPGA-Programm 1 an das weitere FPGA-Programm 1a versendet. Aus dem weiteren FPGA-Programm 1a liest das Überwachungsprogramm 4 den empfangenen Signalwert als Referenzwert aus. Aus dem Vergleich des Signalwertes aus dem FPGA-Programm mit dem Referenzwert aus dem weiteren FPGA-Programm kann das Überwachungsprogramm 4 auf Fehler in der Kommunikation zwischen dem FPGA 2 und dem weiteren FPGA 2a schließen.

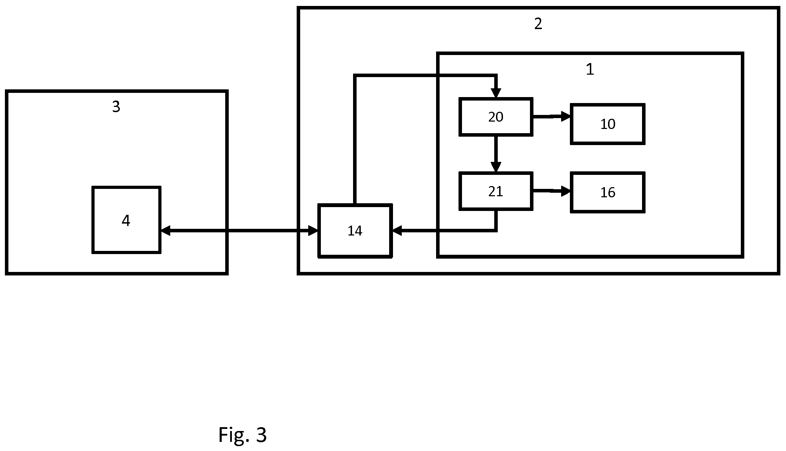

In der Abbildung der Figur 3 ist eine weitere Ausführungsform dargestellt. Im Folgenden werden nur die Unterschiede zu der Abbildung der Figur 1 erläutert. Im FPGA-Programm 1 ist eine Schieberegisterkette bestehend aus einem ersten Schieberegister 20 und einem zweiten Schieberegister 21 implementiert. Der Prozessor 3 kann über den Controller 14 den Inhalt der Schieberegister 20, 21 überschreiben. Mit einem speziellen Signal, einem sogenannten "enable-signal", werden die Inhalte der Schieberegister 20, 21 in Arbeitsregister des ersten FPGA-Programms 1 übernommen. So überschreibt der Inhalt des ersten Schieberegisters 20 den Wert der Konstanten 10. Der Inhalt des Schieberegisters 21 überschreibt den Wert eines weiteren Registers 16. Wenn die Funktionsweise des FPGA-Programms 1 bekannt ist, kann vorhergesagt werden wann und wie sich die Änderung der Konstanten 10 auf Signalwerte auswirkt. Das Überwachungsprogramm 4 kann den Signalwert auslesen und auf Korrektheit prüfen.

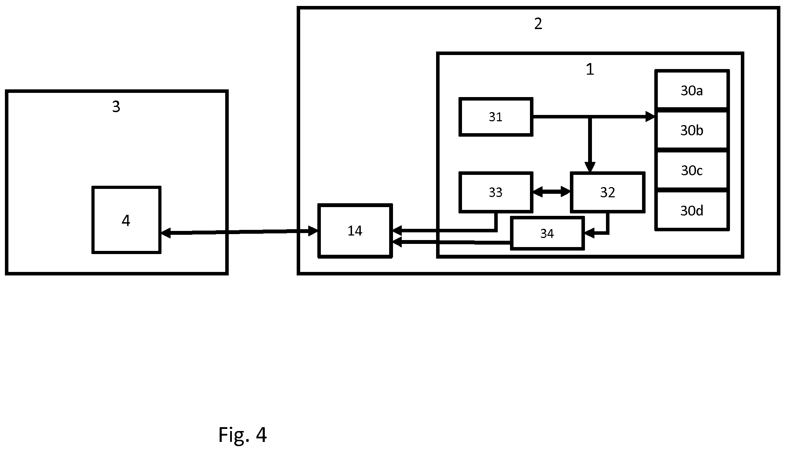

In der Abbildung der Figur 4 ist eine weitere Ausführungsform dargestellt. Im FPGA 2 wird vom FPGA-Programm 1 der BlockRAM in mehrere Partitionen 30a, 30b, 30c, 30d aufgeteilt. Wenn von einem Logikblock 31 auf eine Partition des BlockRAM zugegriffen wird, werden die Zugriffsadresse und die Art des Zugriffs, also lesend oder schreibend, von einem Überwachungsmodul 32 verarbeitet. Bei schreibenden Zugriffen prüft das Überwachungsmodul ob die Zugriffsadresse ein neuer Referenzwert ist und speichert den aktuellen Referenzwert in einem Referenzregister 33. Bei einem lesenden Zugriff wird die Zugriffsadresse als Signalwert in einem Zugriffsregister 34 gespeichert. Das Überwachungsprogramm 4 auf dem Prozessor 3 kann über den Controller 14 den Referenzwert aus dem Referenzregister 33 und den Signalwert aus dem Zugriffsregister 34 auslesen. Falls der Referenzwert ein oberer Grenzwert ist und der Signalwert größer ist als der Referenzwert, so wird vom Überwachungsprogramm 4 ein Fehler erkannt. Falls der Referenzwert ein unterer Grenzwert ist und der Signalwert kleiner ist als der Referenzwert, so wird vom Überwachungsprogramm 4 ein Fehler erkannt. Für jede Partition können ein oberer Grenzwert und/oder ein unterer Grenzwert vorgesehen sein.

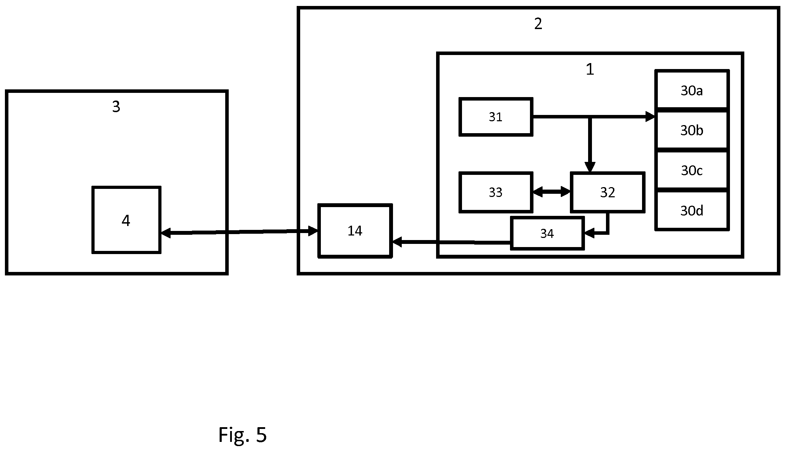

In der Abbildung der Figur 5 ist eine weitere Ausführungsform dargestellt. Im Weiteren werden nur die Unterschiede zu Figur 4 erläutert. In dieser Ausführungsform prüft das Überwachungsmodul 32 bei einem lesenden Zugriff direkt ob die Zugriffsadresse größer als ein oberer Grenzwert oder kleiner als ein unterer Grenzwert ist. Falls der Referenzwert ein oberer Grenzwert ist und der Signalwert größer ist als der Referenzwert, so werden vom Überwachungsmodul 32 als Signalwert ein Fehlerbit und/oder die Zugriffsadresse im Zugriffsregister 34 gespeichert. Der Signalwert wird vom Überwachungsprogramm 4 ausgelesen.

## Patentansprüche

1. Verfahren zur Fehlererkennung eines ersten FPGA-Programms (1), wobei das FPGA-Programm (1) auf einem FPGA (2) ausgeführt wird, wobei der FPGA (2) mit einem Prozessor (3) verbunden ist, wobei auf dem Prozessor (3) ein Überwachungsprogramm (4) ausgeführt wird,
**dadurch gekennzeichnet, dass**
ein Signalwert (5, 6, 7, 8) aus dem FPGA-Programm (1) ausgelesen und dem Überwachungsprogramm (4) zugeleitet wird,
wobei das Überwachungsprogramm (4) zur Erkennung von Fehlern den Signalwert (5, 6, 7, 8) mit einem Referenzwert (9) aus einer anderen Quelle vergleicht.

2. Verfahren nach Anspruch 1,
**dadurch kennzeichnet, dass** eine Vielzahl an Vergleichen zwischen Signalwerten (5, 6, 7, 8) und Referenzwerten (9) durchgeführt und miteinander verknüpft werden.

3. Verfahren nach Anspruch 2,
**dadurch gekennzeichnet, dass** Signalwerte (5, 6, 7, 8) häufiger mit Referenzwerten (9) verglichen werden, wenn ihre Speicherstellen und/oder die Logik (11, 12, 13), aus der sich die Werte der Speicherstellen ergeben einer höheren thermischen Belastung ausgesetzt sind.

4. Verfahren nach Anspruch 3,
**dadurch gekennzeichnet, dass** die thermische Belastung der Speicherstellen durch eine Simulation geschätzt wird.

5. Verfahren nach einem der vorhergehenden Ansprüche,
**dadurch gekennzeichnet, dass** der Referenzwert (9) ein vorgegebener Wert ist.

6. Verfahren nach einem der vorhergehenden Ansprüche,
**dadurch gekennzeichnet, dass** der Signalwert (5, 6, 7, 8) und der Referenzwert (9) jeweils eine Speicheradresse im BlockRAM des FPGA benennen.

7. Verfahren nach einem der vorhergehenden Ansprüche,
**dadurch gekennzeichnet, dass** ein Fehler des FPGA-Programms (1) festgestellt wird, wenn der Signalwert (5, 6, 7, 8) größer als ein erster Referenzwert (9) und/oder kleiner als ein zweiter Referenzwert (9) ist.

8. Verfahren nach Anspruch 6 oder 7,
**dadurch gekennzeichnet, dass** bei einem Schreibzugriff auf den BlockRAM (30) des FPGA ein Referenzwert gesetzt wird.

9. Verfahren nach einem der Ansprüche 6 bis 8,
**dadurch gekennzeichnet, dass** der BlockRAM in eine Vielzahl von Partitionen (30a, 30b, 30c, 30d) unterteilt und für jede Partition (30a, 30b, 30c, 30d) zumindest ein Referenzwert verwendet wird.

10. Verfahren nach Anspruch 1 oder 2,
**dadurch gekennzeichnet, dass** der Prozessor (3) mit einem weiteren FPGA (2a) verbunden ist und der Referenzwert (9) aus dem weiteren FPGA (2a) ausgelesen wird.

11. Verfahren nach einem der Ansprüche 1 bis 5,
**dadurch gekennzeichnet, dass** der Referenzwert (9) dynamisch im Prozessor (3) erzeugt wird.

12. Verfahren nach einem der vorhergehenden Ansprüche,
**dadurch gekennzeichnet, dass** das Überwachungsprogramm (4) einen Stimulationswert an den FPGA sendet.

13. Verfahren nach Anspruch 12,
**dadurch gekennzeichnet, dass** der Stimulationswert eine Konstante im FPGA-Programm (1) überschreibt.

14. Verfahren nach einem der vorhergehenden Ansprüche,
**dadurch gekennzeichnet, dass** der Signalwert (5, 6, 7, 8) über Readback aus dem FPGA (2) ausgelesen wird.
